# EUROPEAN PATENT APPLICATION

(11) **EP 4 216 268 A1**
(43) Date of publication of application: **26.07.2023**
(21) Application number: 22152680.9
(22) Date of filing: 21.01.2022
(51) Int. Cl.: H01L 23/15, H01L 23/498

(54) **CHIP-SUBSTRATE COMPOSITE SEMICONDUCTOR DEVICE**

(71) Applicant: Infineon Technologies Austria AG, 9500 Villach (AT)
(72) Inventor: FACHMANN, Christian, 9586 Fürnitz (AT); GLANZER, Barbara Angela, 9020 Klagenfurt (AT); RIEGLER, Andreas, 9241 Lichtpold (AT)
(74) Representative: Lambsdorff & Lange Patentanwälte Partnerschaft mbB

(57) **Abstract**

A semiconductor device comprises a high-voltage semiconductor transistor chip comprising a front side and a backside. A low-voltage load electrode and a control electrode are disposed on the front side of the semiconductor transistor chip. The semiconductor device further comprises a dielectric inorganic substrate comprising a first side and a second side opposite the first side. A pattern of first metal structures is running through the dielectric inorganic substrate, wherein the pattern of first metal structures is connected to the low-voltage load electrode. At least one second metal structure is running through the dielectric inorganic substrate, wherein the second metal structure is connected to the control electrode. The front side of the semiconductor transistor chip is attached to the first side of the dielectric inorganic substrate. The dielectric inorganic substrate has a thickness measured between the first side and the second side of at least 50 µm.

## Description

### Technical Field

This disclosure relates generally to the field of semiconductor devices, and in particular to the field of high-voltage semiconductor transistor chips.

### Background

Packaging of high-voltage (HV) semiconductor chips involves a number of specific problems. Electrode geometries, their spacing and positions must be determined with respect to the HV requirements. For example, the HV edge of the chip is very sensitive to electric field degradation, and any change in the vicinity of the HV edge may adversely affect the edge termination of the chip. For example, there must be a relatively large distance between the semiconductor chip edge and a low-voltage (LV) terminal element (e.g., source terminal element, gate terminal element, sense terminal element) that crosses the chip edge to allow lateral exit of field lines between the chip edge and the LV terminal element. It is also difficult to provide protection against ion or moisture diffusion into the semiconductor chip at the chip edge.

Further aspects aim at cost efficient manufacturing processes and customer benefits in view of product versatileness and package design.

### Summary

According to an aspect of the disclosure a semiconductor device comprises a high-voltage semiconductor transistor chip comprising a front side and a backside. A LV load electrode and a control electrode are disposed on the front side of the semiconductor transistor chip. The semiconductor device further comprises a dielectric inorganic substrate comprising a first side and a second side opposite the first side. A pattern of first metal structures is running through the dielectric inorganic substrate, wherein the pattern of first metal structures is connected to the LV load electrode. At least one second metal structure is running through the dielectric inorganic substrate, wherein the second metal structure is connected to the control electrode. The front side of the semiconductor transistor chip is attached to the first side of the dielectric inorganic substrate. The dielectric inorganic substrate has a thickness measured between the first side and the second side of at least 50 µm.

### Brief description of the drawings

The elements of the drawings are not necessarily to scale relative to each other. Like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.

Figure 1 is a schematic cross-sectional view of an exemplary semiconductor device comprising a semiconductor chip and a dielectric inorganic substrate along line X-X of Figure 2A.

Figure 2A is a top view on the (transparent) dielectric inorganic substrate of the exemplary semiconductor device of Figure 1.

Figure 2B is a partial view of a detail D of Figure 2A.

Figure 3A is a schematic cross-sectional view of an exemplary semiconductor device similar to Figure 1, wherein a small control electrode or a control ring is used as a control contact on the semiconductor chip.

Figure 3B is a schematic cross-sectional view of an exemplary semiconductor device similar to Figure 3A, wherein a control electrode pad on the dielectric inorganic substrate extends near to the chip edge so as to overlap with a HV electrode ring.

Figure 4A is a schematic cross-sectional view of an exemplary semiconductor device comprising a semiconductor chip and a dielectric inorganic substrate along line Y-Y of Figure 4B, wherein a control electrode ring is embedded in the dielectric inorganic substrate.

Figure 4B is a top view on the (transparent) dielectric inorganic substrate of the exemplary semiconductor device of Figure 4A.

Figure 4C is a schematic cross-sectional view of an exemplary semiconductor device comprising a semiconductor chip and a dielectric inorganic substrate, wherein a control electrode ring is embedded in the dielectric inorganic substrate and surrounds the pattern of first metal structures connected to the LV load electrode.

Figure 4D is a schematic cross-sectional view of an exemplary semiconductor device comprising a semiconductor chip and a dielectric inorganic substrate along line Z-Z of Figure 4E, wherein a control electrode finger is embedded in the dielectric inorganic substrate.

Figure 4E is a top view on the (transparent) dielectric inorganic substrate of the exemplary semiconductor device of Figure 4D.

Figure 5A is a schematic cross-sectional view of an exemplary semiconductor device comprising a semiconductor chip and a dielectric inorganic substrate along line W-W of Figure 5B, wherein floating HV electrode rings are embedded in the dielectric inorganic substrate.

Figure 5B is a top view on the (transparent) dielectric inorganic substrate of the exemplary semiconductor device of Figure 5A.

Figure 5C is a schematic cross-sectional view of an exemplary semiconductor device comprising a semiconductor chip and a dielectric inorganic substrate, wherein HV and/or LV field plates are embedded in the dielectric inorganic substrate.

Figure 5D is a schematic cross-sectional view similar to Figure 5C, wherein overlapping HV and LV metallizations are formed in or on the dielectric inorganic substrate.

Figure 6A is a schematic cross-sectional view of an exemplary semiconductor device comprising a semiconductor chip and a dielectric inorganic substrate, wherein a barrier layer is disposed on the dielectric inorganic substrate.

Figures 6B-6C illustrate stages of a process of forming a barrier layer on the dielectric inorganic substrate.

Figure 6D is a schematic cross-sectional view similar to Figure 6A, wherein the dielectric inorganic substrate is provided with a HV metallization.

Figure 7 is a schematic cross-sectional view of an exemplary semiconductor device comprising a semiconductor chip and a dielectric inorganic substrate, wherein an active or passive electrical component is mounted on the dielectric inorganic substrate.

Figure 8 is a schematic cross-sectional view of an exemplary semiconductor device comprising a semiconductor chip and a dielectric inorganic substrate, wherein an intermediate voltage region on the semiconductor transistor chip is contacted through the dielectric inorganic substrate.

Figure 9 is a schematic cross-sectional view of an exemplary dielectric inorganic substrate including a plurality of stacked dielectric inorganic substrate layers.

Figures 10A-10L are schematic cross-sectional views illustrating exemplary stages of manufacturing an exemplary semiconductor device in accordance with the disclosure.

### Detailed description

As used in this specification, the terms "electrically connected" or "connected" or similar terms are not meant to mean that the elements are directly contacted together; intervening elements may be provided between the "electrically connected" or "connected" elements, respectively. However, in accordance with the disclosure, the above-mentioned and similar terms may, optionally, also have the specific meaning that the elements are directly contacted together, i.e. that no intervening elements are provided between the "electrically connected" or "connected" elements, respectively.

Further, the words "over" or "beneath" with regard to a part, element or material layer formed or located "over" or "beneath" a surface may be used herein to mean that the part, element or material layer be located (e.g. placed, formed, arranged, deposited, etc.) "directly on" or "directly under", e.g. in direct contact with, the implied surface. The word "over" or "beneath" used with regard to a part, element or material layer formed or located "over" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

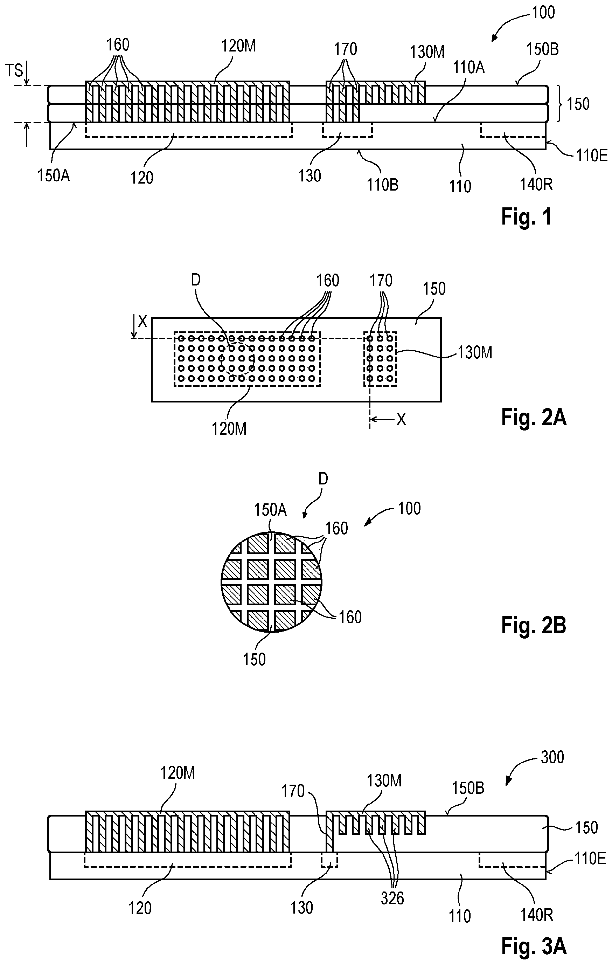

Figure 1 illustrates a schematic cross-sectional view of an exemplary semiconductor device 100. The semiconductor device 100 includes a semiconductor transistor chip 110. The semiconductor transistor chip 110 is a HV semiconductor transistor chip that operates at a supply voltage (e.g. drain voltage) equal to or higher than, e.g., 100 V, 200 V, 300 V, 400 V, 500 V, 600 V, 700 V, 800 V, 900 V, or 1000 V. In particular, the semiconductor transistor chip 110 may operate at a supply voltage in a range between 300 V and 800 V.

The semiconductor transistor chip 110 has a front side 110A and a backside 110B. A LV load electrode 120 and a control electrode 130 are disposed on the front side 110A of the semiconductor transistor chip 110. A HV load electrode (not shown) is disposed either on the front side 110A or on the backside 110B of the semiconductor transistor chip 110..

The semiconductor transistor chip 110 includes an integrated power device such as, e.g., a power transistor. For instance, the semiconductor transistor chip 110 may be configured as including one or more MISFETs (Metal Insulator Semiconductor Field Effect Transistors), MOSFETs (Metal Oxide Semiconductor Field Effect Transistors), IGBTs (Insulated Gate Bipolar Transistors), JFETs (Junction Gate Field Effect Transistors), HEMTs (High Electron Mobility Transistors) or bipolar transistors. The semiconductor transistor chip 110 may be a vertical transistor device.

The semiconductor transistor chip 110 may, e.g., be made of any semiconductor material, e.g. Si, SiC, SiGe, GaAs, GaN, AlGaN, InGaAs, InAlAs, etc. In particular, HV Si or SiC transistor chips 110 are considered herein.

A dielectric inorganic substrate 150 is attached to the front side 110A of the semiconductor transistor chip 110. More specifically, the front side 110A of the semiconductor transistor chip 110 is attached to a first surface 150A of the dielectric inorganic substrate 150 by, e.g., a wafer bond connection (not shown). The front side 110A of the semiconductor transistor chip 110 may be completely covered by the dielectric inorganic substrate 150. In particular, the dielectric inorganic substrate 150 may be a glass substrate and the wafer bond connection may, e.g., be a glass frit connection.

The dielectric inorganic substrate 150 comprises a pattern of first metal structures 160. The first metal structures 160 may be accommodated in recesses of the dielectric inorganic substrate 150. The first metal structures 160 run through the dielectric inorganic substrate 150, wherein the pattern of first metal structures 160 is connected to the LV load electrode 120. The LV load electrode 120 may, e.g., be the source electrode or the emitter electrode of the semiconductor transistor chip 110.

The dielectric inorganic substrate 150 further comprises at least one second metal structure 170 running through the dielectric inorganic substrate 150. The second metal structure 170 is connected to the control electrode 130. The control electrode 130 may, e.g., form the gate electrode of the semiconductor transistor chip 110.

The first and second metal structures 160, 170 may be formed of plated metal pillars. To this end, before the dielectric inorganic substrate 150 is bonded to the wafer from which the semiconductor transistor chip 110 is later singulated, recesses or through holes are formed in the dielectric inorganic substrate 150. The first and second metal structures 160, 170 may then be formed in the recesses or through holes of the dielectric inorganic substrate 150 by metal plating as will be described in greater detail further below.

The dielectric inorganic substrate 150 may be a glass substrate or a semiconductor substrate. If the metal structures 160, 170 are required to be electrically insulated from each other, glass or an intrinsic semiconductor substrate material or a semiconductor substrate having recesses with insulated side walls could be used. Recesses with insulated side walls may, e.g., be formed by applying an insulating layer (e.g. a silicon oxide layer or a silicon nitride layer) to the side walls of the recesses in which the first and second metal structures 160, 170 are accommodated.

As will be described in more detail further below, the dielectric inorganic substrate 150 may optionally comprise or be composed of a plurality of stacked dielectric inorganic substrate layers 150_1, 150_2, ....

The semiconductor device 100 may be referred to as a composite chip or substrate-semiconductor hetero-structure. Such composite chip may be diced out of a composite wafer which may comprise a semiconductor wafer and a dielectric inorganic substrate wafer bonded together by a wafer bond connection.

Such composite chips offer a number of advantages, especially for designing and/or packaging HV transistor chips.

First, by integrating the permanent dielectric inorganic substrate 150 together with the semiconductor transistor chip 110 in a package, the dielectric inorganic substrate 150 may be used as an "adapter" that can be appropriately structured and metallized to make the composite chip directly solderable to a package-internal terminal structure or package-external circuitry such as, e.g., a leadframe or an application board or other internal or external terminal structures of a given geometry.

For example, the first metal structures 160 may end in a substrate metallization 120M representing the LV load electrode 120 of the semiconductor device (composite chip) 100 and extending on a second surface 150B of the dielectric inorganic substrate 150. Accordingly, the one or more second metal structures 170 may end in a substrate metallization 130M which represents the control electrode 130 of the semiconductor device (composite chip) 100. As the substrate metallizations 120M and 130M are spaced apart from the semiconductor transistor chip 110 by the dielectric inorganic substrate 150, constrains in terms of their geometries are substantially relaxed. For this and other reasons, the geometries of the LV substrate metallizations 120M, 130M may be changed with regard to the geometries of the LV load electrode 120 and the control electrode 130, respectively.

In other words, the dielectric inorganic substrate 150 may e.g. be useful as a "chip electrode layout adaptor" between the semiconductor transistor chip 110 and a terminal geometry provided internal (e.g. by a leadframe) or external (e.g. by an application board) of a HV semiconductor package which includes the semiconductor device 100. This allows direct bonding of the "adapted" chip front side electrodes (namely the substrate metallizations 120M, 130M) to a terminal structure (e.g. leadframe) without requiring changes in chip processing when the terminal structure geometry (e.g. leadframe design) is modified. Further, such "chip electrode layout adaptor" may be useful if already available chip types are to be packaged in a package using a given terminal structure geometry (e.g. leadframe geometry).

As a second aspect, the implementation of the dielectric inorganic substrate 150 allows to process very thin semiconductor wafers when being supported by the dielectric inorganic substrate wafer. Therefore, HV semiconductor transistor chips 110 with advanced electrical and thermal properties may be used.

Third, in the case of HV semiconductor transistor chips 110, there needs to be a relatively large spacing between the front side 110A of the semiconductor transistor chip 110 and a LV connection element (e.g. LV load electrode connection element or control electrode connection element) that extends laterally across a chip edge 110E of the semiconductor transistor chip 110. This spacing is required because the chip edge 110E of HV transistor chips 110 is typically at a rapidly changing HV potential. Figure 1 illustrates a HV load electrode ring 140R extending adjacent to the edge 110E of the semiconductor transistor chip 110, wherein the HV load electrode ring 140R is held on the potential of the HV load electrode (not shown). The HV load electrode may, e.g., be the drain or collector electrode of the semiconductor transistor chip 110.

For example, while the voltage fluctuations at the LV load electrode 120 and the control electrode 130 of the semiconductor transistor chip 110 are, e.g., between 0.1 - 3 V at the low voltage load electrode and, e.g., between 0 - 20 V at the control electrode, the voltage fluctuations at the edge 110E of the semiconductor transistor chip 110 are between 0 V and e.g. 300 to 800 V or even 1000 V with a frequency of typically several 100 kHz. The relatively large spacing between the front side 110A of the semiconductor transistor chip 110 and LV connecting elements (e.g. package terminals or a leadframe or conductor traces of an application board) extending across the edge 110E of the semiconductor transistor chip 110 allow the field lines to escape laterally between the LV connecting elements (not shown) and the chip edge 110E.

This distance is created by designing the dielectric inorganic substrate 150 with a sufficient thickness TS. Thus, the dielectric inorganic substrate 150 acts as an "extension" to allow field lines to exit laterally between LV terminal elements and the HV chip edge 110E. For example, the dielectric inorganic substrate 150 may have a thickness TS which may be equal to or greater than or less than 50 µm or 100 µm or 200 µm or 300 µm or 400 µm. While for SiC or other high bandgap semiconductor materials, a thickness TS of 50 µm may, e.g., be sufficient, Si semiconductor transistor chips 110 advantageously may use a dielectric inorganic substrate 150 of a thickness TS of equal to or greater than 100 µm.

The second surface 150B of the dielectric inorganic substrate 150 may be (highly) planar. The second surface 150B of the dielectric inorganic substrate 150 may be parallel with the backside 110B of the semiconductor transistor chip 110.

As apparent from Figures 2A and 2B, the first metal structures 160 may be arranged in a densely packed array in the dielectric inorganic substrate 150. Differently put, the dielectric inorganic substrate 150 may form a matrix for the pattern or array of first metal structures 160. The percentage in volume of metal within the pattern or array of the first metal structures 160 in the dielectric inorganic substrate 150 may be high, e.g. equal to or greater than, e.g., 40% or 50% or 60% or 70% or 80%.

The pattern of first metal structures 160 may, e.g., be a regular array. A pitch of the pattern of first metal structures 160 may, e.g., be equal to or greater than or less than 15 µm or 17.5 µm or 20 µm or 22.5 µm or 25 µm or 27.5 µm or 30 µm. A distance between adjacent first metal structures 160 may, e.g., be equal to or greater than or less than 50 µm or 30 µm or 10 µm or 5 µm or 4 µm or 3 µm or 2 µm. The lateral dimension(s) of each first metal structure 160 may, e.g., be equal to or greater than or less than 12.5 µm or 15 µm or 17.5 µm or 20 µm or 22.5 µm or 25 µm or 27.5 µm. A a ratio of a distance between adjacent first metal structures 160 and a lateral dimension (e.g. diameter) of a first metal structure 160 may be equal to or less than 5 or 3 or 2 or 1.

Referring to Figure 2A, the dielectric inorganic substrate 150 may, e.g., have a polygonal, in particular rectangular shape.

By virtue of the dielectric inorganic substrate 150, the semiconductor device 100 may have advanced heat dissipation properties. Heat dissipation in semiconductor devices 100 relies, inter alia, on the electrical interconnect between the semiconductor transistor chip 110 and a terminal structure (e.g. leadframe or application board or conductor traces of an application board, etc.) on which the semiconductor transistor chip 110 is mounted. Here, this electrical interconnect includes or is composed of the pattern of first metal structures 160 in the dielectric inorganic substrate 150.

The pattern of first metal structures 160 can be optimized in terms of thermal conductivity and/or heat capacity. The more densely the first metal structures 160 are packed in the dielectric inorganic substrate 150, the better the heat conductivity and the thermal capacity of the dielectric inorganic substrate 150. Further, enhancing the thickness TS of the dielectric inorganic structure 150 increases the thermal capacity thereof, because more metal is held available in the dielectric inorganic structure 150 for transient heat absorption.

The second metal structure(s) 170 may be implemented the same way as described above for the first metal structures 160, and reiteration is avoided for the sake of brevity. However, as the second metal structure(s) 170 connect(s) to a low current control electrode, it is also possible that only a single second metal structure (i.e. a single metal pillar connecting between the control electrode 130 and the substrate metallization 130M of the control electrode) is sufficient.

Returning to Figure 2B, the first metal structures 160 may, e.g., have a polygonal (square, hexagonal, etc.) or rounded cross-section. A square cross-section shape is exemplarily shown in Figure 2B. A hexagonal cross-sectional shape may be beneficial as it provides for a particular high area packing density of metal in the dielectric inorganic structure 150.

Each first metal structure 160 may be linear and/or have an axially symmetric cross-sectional shape. Furthermore, each first metal structure 160 may have a substantially constant cross-sectional shape along its extension through the dielectric inorganic substrate 150. Variable-cross sectional shapes along the longitudinal extension such as, e.g., tapering shapes or bulges or thickenings are also possible.

Moreover, the pattern does not need to be designed as a regular array. Rather, the pattern may be composed of a plurality of different patterns or (e.g. regular) arrays. Such different patterns (e.g. sub-patterns) or arrays (e.g. sub-arrays) may distinguish from each other e.g. in terms of pitch and/or cross-sectional shape of the first metal structures 160.

Generally, the dielectric inorganic substrate 150 offers a variety of approaches to become geometry and/or process independent from the semiconductor wafer. In particular, it is possible to relocate structures which are normally realized in or on the semiconductor transistor chip 110 partially or completely out of the semiconductor transistor chip 110 into or onto the dielectric inorganic substrate 150. This makes it possible to provide the necessary area for a control pad on the second surface 150B of the dielectric inorganic substrate 150 to fulfill all bond wire rules for a respective package. On the other hand, the area of the control electrode 130 on the semiconductor transistor chip 110 can be made very small, because it is not connected by a package terminal such as, e.g., a bond wire. This allows the area consumption of the control electrode 130 to be reduced in line with the shrinking semiconductor area of semiconductor devices 100 from generation to generation, thereby reducing the chip cost.

Figure 3A illustrates an exemplary semiconductor device 300. A control pad formed by the substrate metallization 130M is disposed on the second surface 150B of the dielectric inorganic substrate 150. An area of the control pad (metallization 130M) may be greater than an area of the control electrode 130 by, e.g., at least a factor 3 or 5 or 10 or 50 or 100. For example, the control electrode 130 may have an area with lateral dimensions between, e.g., 5 and 50 µm, in particular between 10 and 25 pm, which is sufficient for electrical bonding to a second metal structure 170. On the other hand, the control pad (metallization 130M) may have, for example, an area of 500 µm × 500 µm sufficient for, e.g., wire bonding.

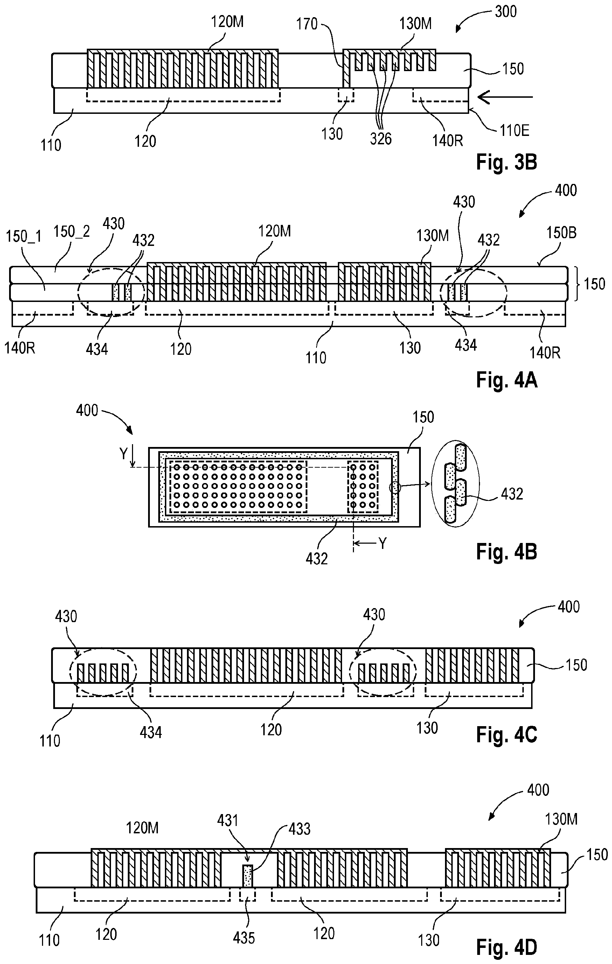

Hence, the area of the control electrode 130 on the semiconductor transistor chip 110 may be reduced to the area of a single second metal structure 170 (e.g. Cu pillar). Furthermore, it is possible that no separate control electrode (e.g. gate electrode) is required on the semiconductor transistor chip 110, but a control electrode ring or a control electrode finger (e.g. gate ring or gate finger, see Figures 4A-4E) is used as a control electrode contact. In this case, the control electrode 130, shown in Figures 3A and 3B, can even be omitted and would be replaced by a contact to the control electrode ring or control electrode finger. The advantage is a significantly reduced chip area for high impedance semiconductor devices 300.

Differently put, the control electrode area on the semiconductor transistor chip 110 may be substantially smaller (or even zero) than on the top of the composite chip (semiconductor device 300). Besides the better connectivity of the semiconductor device 300 and the possibility of reducing the chip size (see also Figure 3B), this approach may also be beneficial in that different packages may be serviced by combining with different control pad layouts (metallization 130M layouts) without having to adjust the electrode layout on the semiconductor transistor chip 110. This provides for chip cost advantages and reduction of the manufacturing complexity.

Another example of the semiconductor device 300 is shown Figure 3B. Here, the reduced area of the control electrode 130 is exploited to place the control pad (metallization 130M) closer to the edge 110E of the semiconductor transistor chip 110 than in Figure 3A (see arrow). In particular, the outer edge of the control pad (metallization 130M) may be closer to the edge 110E of the semiconductor transistor chip 110 than the outer edge of the control electrode 130. Likewise, this may allow to reduce the overall size of the semiconductor transistor chip 110, since the control pad (metallization 130M) on the upper side of the dielectric inorganic substrate 150 can extend further into the chip edge region than would be possible directly on the semiconductor chip due to the greater distance (thickness TS) to the front side 110A of the semiconductor transistor chip 110. For example, as shown in Figure 3B, it is possible to overlap the control pad (metallization 130M) with the HV load electrode ring 140R.

Further, as shown for example in Figures 1, 3A and 3B, the control electrode 130 may optionally be electrically connected to control electrode field plates 326. The control electrode field plates 326 are vertical metal structures extending into the dielectric inorganic substrate 150. The control electrode field plates 326 may be electrically connected to the substrate metallization 130M and may form blind hole metal structures which do not extend through the dielectric inorganic substrate 150. For example, as shown in Figure 3B, it is possible to overlap the control electrode field plates 326 with the HV load electrode ring 140R.

Moreover, it is also possible to contact different chip areas "directly" to provide further pads at the second surface 150B of the dielectric inorganic substrate 150 for, e.g. further control pads (gate pads), connections for a split gate or a temperature sensor etc.

Figures 4A to 4E illustrate examples of an exemplary semiconductor device 400. In semiconductor device 400, the dielectric inorganic substrate 150 is used to improve chip area efficiency by rewiring a control electrode ring (so-called gate ring) and/or a control electrode finger (so-called gate finger) within the dielectric inorganic substrate 150.

As known in the art, lateral gate structures such as gate rings (which surround the active area of the semiconductor transistor chip 110) and gate fingers (which extend into the active area of the semiconductor transistor chip 110) may be used to ensure a high performance (e.g. a high switching speed) of the semiconductor transistor chip 110. Such lateral control electrode elements need to have a minimum width sufficient for avoiding electro-migration due to the relatively high gate current as well as a reduction of the distributed gate resistance. For low R_{DS(on),} the area consumption of such lateral gate structures is relatively high, e.g. about 10-100 µm in width for a gate ring and about 25-150 µm in width for gate fingers.

The dielectric inorganic substrate 150 allows to transform such lateral gate structures into vertical gate structures which are partly or completely located in the dielectric inorganic substrate 150. Thereby, the chip area can be reduced since only the minimum electrically required width of such structures on the semiconductor transistor chip 110 needs to be maintained (while current can be outsourced into the vertical gate structures).

Referring to Figures 4A and 4B, the dielectric inorganic substrate 150 includes a control electrode ring (gate ring) 430 which surrounds an active area of the semiconductor transistor chip 110 in a vertical projection. At least a part of the control electrode ring 430 is embedded in the dielectric inorganic substrate 150.

More specifically, the dielectric inorganic substrate 150 may be provided with one or more fourth metal structures 432, which are connected to a control electrode chip ring 434 provided in the semiconductor transistor chip 110. The control electrode chip ring 434 may be designed in the conventional way, however with a significantly smaller width since the electro-migration and the resistance of the "composite" control electrode ring 430 are reduced by the fourth metal structure(s) 432 embedded in the dielectric inorganic substrate 150. Differently stated, the fourth metal structure(s) 432 provide(s) for an additional wiring level for the control electrode ring 430 and thus improve(s) the electrical behavior of the control electrode ring 430 and, as a result, of the performance of the semiconductor transistor chip 110. As shown in the enlarged section of Figure 4B, the fourth metal structures 432 laterally connect to each other and/or are formed as a continuous ring trench.

The additional vertical structure provided by the fourth metal structure(s) 432 may not extend up to the second surface 150B of the dielectric inorganic substrate 150. As will be described further below, this may either be achieved by composing the dielectric inorganic substrate 150 of multiple dielectric inorganic substrate layers 150_1, 150_2, ... with only the lower dielectric inorganic substrate layer(s) 150_1 be provided with the fourth metal structure(s) 432, or by using recesses for the fourth metal structures 432 having a narrower opening so that the recesses (e.g. holes or trenches etc.) become less deep in the structuring process. That way, the fourth metal structures 432 may be fabricated only in a lower area of the dielectric inorganic substrate 150.

In the example shown in Figures 4A and 4B the control electrode ring 430 surrounds the LV load electrode 120 and the control electrode 130. Figure 4C illustrates a semiconductor device 400 in which the control electrode ring 430 surrounds the LV load electrode 120 but not the control electrode 130. Apart from this, features of the semiconductor device 400 of Figure 4C may be similar or identical to the features of the semiconductor device 400 of Figures 4A and 4B and reference is made to the above description to avoid reiteration.

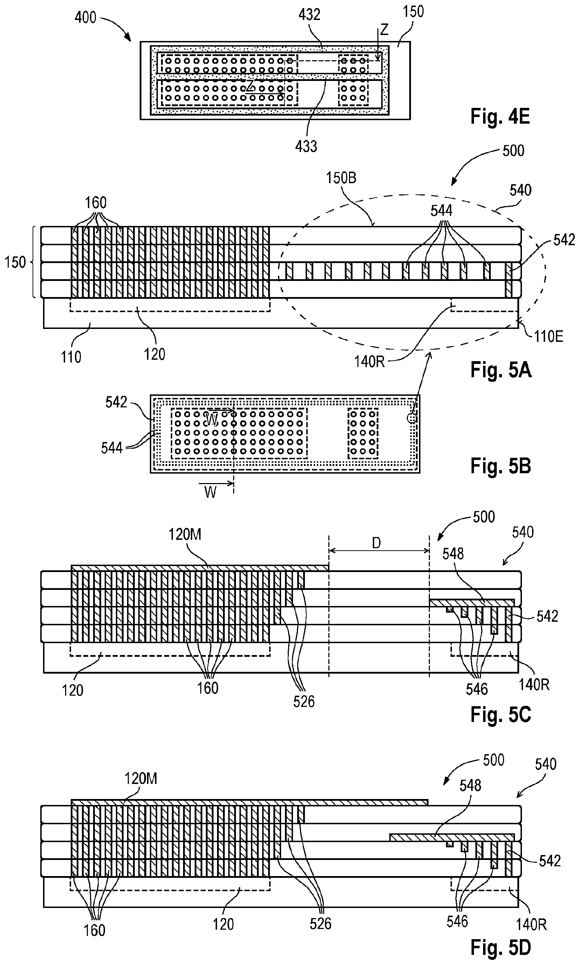

Figures 4D and 4E illustrate a further example of a semiconductor device 400 which is provided with at least one control electrode finger 431. The control electrode finger 431 extends into an active area of the semiconductor transistor chip 110 in a vertical projection. Further, the control electrode finger 431 is electrically connected to the control electrode ring 430.

As apparent from Figures 4D and 4E, the control electrode finger 431 is (at least partly) embedded in the dielectric inorganic substrate 150. More specifically, the control electrode finger 431 may include a fifth metal structure 433 and a control electrode chip finger 435. The control electrode chip finger 435 corresponds to a conventional control electrode finger, while the fifth metal structure 433 provided in the dielectric inorganic substrate 150 electrically connects to the control electrode chip finger 435 and thereby provides for the "vertical" extension of the control electrode finger 431.

Rewiring the control electrode chip finger 435 into the dielectric inorganic substrate 150 provides for the same advantages and improvements as rewiring the control electrode chip ring 434 into the dielectric inorganic substrate 150 as mentioned above, and reference is made to the above description to avoid reiteration.

As mentioned before, the degradation of the electrical field at the HV edge 110E of the semiconductor transistor chip 110 is often a limiting factor in HV semiconductor transistor chips (e.g. IGBTs, MOSFETs, etc.). Figures 5A-5B illustrate an example of a semiconductor device 500 in which the dielectric inorganic substrate 150 is used to rewire the chip-based HV load electrode ring 140R into the dielectric inorganic substrate 150.

More specifically, the semiconductor device 500 may include a HV load electrode ring 540 extending adjacent to the edge 110E of the semiconductor transistor chip 110. The HV load electrode ring 540 is partly or completely embedded in the dielectric inorganic substrate 150. More specifically, the HV load electrode ring 540 may include a sixth metal structure 542 electrically connected to the chip-based HV load electrode ring 140R or to any other HV load electrode contact provided in the semiconductor transistor chip 110 near the edge 110E.

In other words, the chip-based HV load electrode ring 140R can be partly or completely outsourced into the dielectric inorganic substrate 150. The HV load electrode ring 540 is typically not exposed at the second surface 150B of the dielectric inorganic substrate 150, i.e. the dielectric inorganic substrate 150 covers the HV potential (e.g. drain potential).

HV electrode fingers (so-called drain fingers - not shown) can extend inward from the HV load electrode ring 540 into the active area of the semiconductor transistor chip 110 for a better HV load electrode contact.

Further, the HV load electrode ring 540 may include electrically floating rings 544 embedded in the dielectric inorganic substrate 150. For the same reasons as explained above, the electrically floating rings 544 may be arranged with a small pitch of only a few or a few tens of micrometers. They are effective means of preventing ion penetration into the active area of the semiconductor transistor chip 110 and thus build a long-term drift stable edge 110E of the semiconductor transistor chip 110. If realized in the semiconductor transistor chip 110, they would, however, unduly widen the chip edge region and therefore increase the semiconductor area consumption.

Hence, the dielectric inorganic substrate 150 allows to redesign the chip edge 110E which is critical in terms of field degradation and ion penetration by the addition of vertical structures (sixth metal structure(s) 542 and/or electrically floating rings 544) to improve electrical behavior, long term drift stability and semiconductor area consumption of the semiconductor device 500.

It is to be note that the rings 544 need not be electrically floating, but may alternatively be controlled by one or more electrical potentials tapped, for example, from the semiconductor transistor chip 110.

Referring to Figures 5C to 5D, an example of a semiconductor device 500 is provided with HV load electrode field plates. The HV electrode field plates include seventh metal structures 546 extending in a vertical direction in the dielectric inorganic substrate 150. The seventh metal structures 546 may be electrically connected by a horizontal interconnect structure 548 which is electrically connected e.g. via the sixth metal structure 542 to HV potential. Similar as the electrically floating rings 544, the seventh metal structures 546 (HV field plates) are advantageous to reduce the metallic openings at the chip edge 110E and thus provide a drift-stable edge termination and reduce ion diffusion through the dielectric inorganic substrate 150.

As known in the art, the spacing between the chip-based HV load electrode ring 140R and a LV electrode (e.g. gate electrode, source/emitter electrode, sense electrode), here exemplified by the LV load electrode 120, must be at least 35-45 µm. The rewiring functionality offered by the dielectric inorganic substrate 150 allows to reduce this spacing D as shown in Figure 5C. To this end, the LV load electrode 120 (or any other LV electrode) may be connected to LV field plates 526 which, in this example, are electrically interconnected via the LV load electrode substrate metallization 120M.

As shown in Figure 5D, this approach may even allow for a negative spacing D, i.e. an overlap between the horizontal interconnect structure 548 of the HV load electrode field plates and an interconnect structure (e.g., the substrate metallization 120M) of an LV structure equipped with, for example, LV field plates 526.

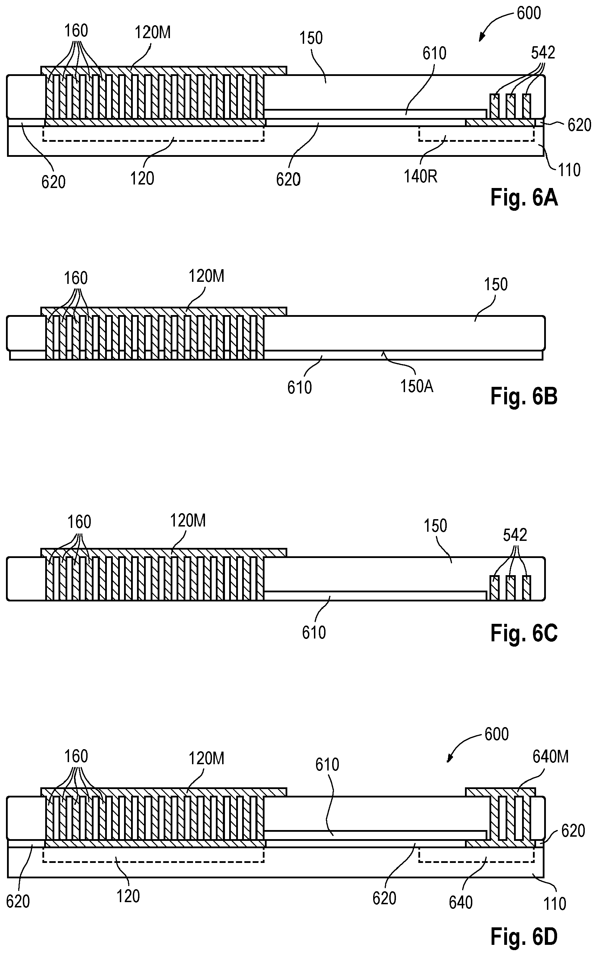

Figures 6A and 6D illustrate an example of a semiconductor device 600 which includes a barrier layer 610 disposed on the first surface 150A of the dielectric inorganic substrate 150. Optionally, an imide layer 620 for preconditioning the wafer surface may be used in this and, e.g., all other embodiments. The barrier layer 610 provides protection against ion diffusion or the penetration of moisture from the dielectric inorganic substrate 150 to the active area of the semiconductor transistor chip 110. The barrier layer 610 may, e.g., comprise or be a nitride barrier layer. The barrier layer 610 may have a thickness of 100 nm or thicker and may reach a maximum thickness of, e.g., one or several µm.

Such barrier layers (in particular nitride barrier layers) often can not be deposited on the semiconductor wafer if the wafer has already been metallized, since too high temperatures are required for deposition. With the dielectric inorganic substrate 150 disclosed herein, it is possible to deposit such barrier layer 610 on the dielectric inorganic substrate 150 before it is metal-plated and bonded to the semiconductor wafer, from which the composite chips (semiconductor devices 600) are later diced.

Figures 6B and 6C illustrate stages of a process of manufacturing the barrier layer 610 on the first surface 150A of the dielectric inorganic substrate 150. Initially, the first surface of the dielectric inorganic substrate 150 is covered by the barrier layer 610. Later, the dielectric inorganic substrate 150 is recessed (e.g. as described further below) and the first metal structures 160 and, e.g. some or all of the further metal structures described herein (e.g. the sixth metal structures 542) are formed in the recesses. The barrier layer 610 is then partially removed to expose the first metal structures 160 at the first surface 150A of the dielectric inorganic substrate 150. Other metal structures such as, e.g., the sixth fifth metal structures 542 may also be exposed at the first surface 150A of the dielectric inorganic substrate 150.

The barrier layer 610 may also be produced on the dielectric inorganic substrate 150 by a CVD (chemical vapor deposition) process. It is to be noted that it may not be possible to apply a CVD process on the semiconductor wafer (there, only sputtering techniques may be usable to deposit the barrier layer 610). The CVD process allows to deposit a denser and thus higher quality barrier layer 610 compared to barrier layers sputtered onto the wafer surface.

Hence, the dielectric inorganic substrate 150 allows to use higher deposition temperatures and modified manufacturing processes for forming barrier layers 610 with improved barrier performance.

The barrier layer 610 may, e.g., be arranged between HV and LV regions, e.g. between a HV load electrode 640 (e.g. drain electrode) and/or a HV load electrode ring 140R and a LV voltage electrode such as, e.g. load electrode 120 and/or the control electrode 130 and/or a sense electrode of the semiconductor transistor chip 110. A HV load electrode metallization 640M may be provided on the dielectric inorganic substrate 150 and connected to the HV load electrode 640.

Further, the barrier layer 610 may surround the semiconductor transistor chip 110 as a closed ring outside or adjacent or partially overlapping the active area.

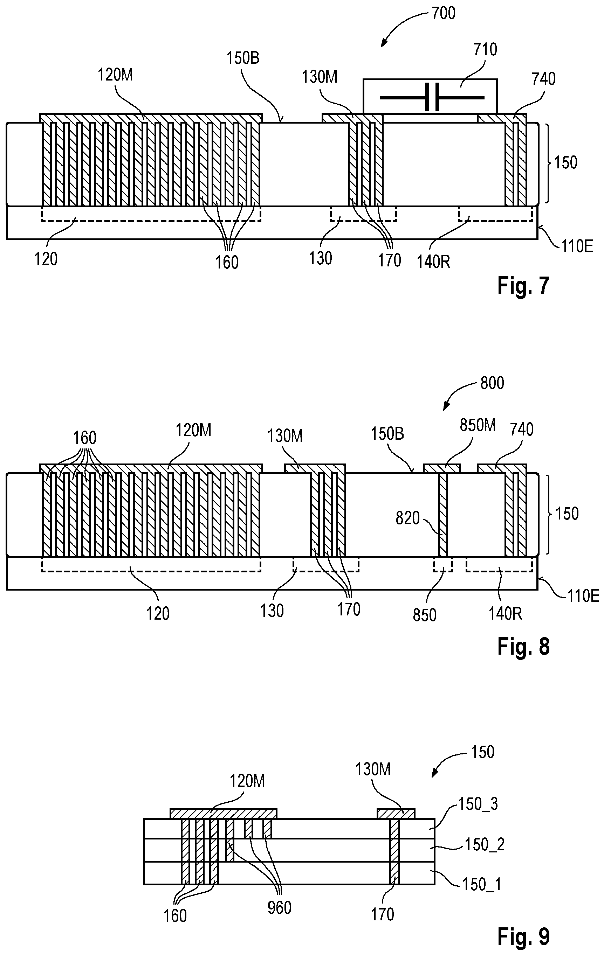

Figure 7 illustrates a semiconductor device 700 in which the distance to the semiconductor transistor chip 110, created by the dielectric inorganic substrate 150, is used to place an electrical component 710 in a low inductive manner over the semiconductor transistor chip 110. The electrical component 710 may be a discrete passive or active electrical component. In particular, the electrical component 710 may be a capacitor, a resistor, an inductor or, as an example of an active component, a diode, e.g. a Zener diode.

The electrical component 710 may be mounted on the second surface 150B of the dielectric inorganic substrate 150. The electrical component 710 may be soldered or otherwise affixed directly to metallizations on the second surface 150B of the dielectric inorganic substrate 150. By using the dielectric inorganic substrate 150, not only the required distance between the semiconductor transistor chip 110 and the electrical component 710 can be guaranteed but also rewiring can be made due to the additional wiring level provided by the second surface 150B of the dielectric inorganic substrate 150. Differently stated, due to the distance to the front side 110A of the semiconductor transistor chip 110, any electrical components 710 can be mounted on the dielectric inorganic substrate 150 without affecting the electrical field over the semiconductor transistor chip 110 and, in particular, at the edge 110E of the semiconductor transistor chip 110 and without reducing the long-term stability of the semiconductor device 700. In particular, no bond wires or other non-optimal connections to the semiconductor transistor chip 110 are required, and in addition, inductive or capacitive parasitics caused by bond wires or such other non-optimal connections are avoided.

The electrical component 710 may be electrically connected between a variety of different electrical contacts provided at the second surface 150B of the dielectric inorganic substrate 150. For example, the electrical component 710 may be electrically connected between a HV metal pad 740 disposed on the second surface 150B of the dielectric inorganic substrate 150 and the substrate metallization 130M connected via the at least one second metal structure 170 to the control electrode 130. The HV metal pad 740 may be electrically connected to the HV load electrode ring 140R or to the HV load electrode (not shown in Figure 7).

Other possibilities are to connect the electrical component 710 between the LV load electrode 120 and the control electrode 130. This can be done by electrically connecting (e.g. direct soldering or otherwise affixing) the electrical component 710 between the substrate metallization 120M of the LV load electrode 120 and the substrate metallization 130M of the control electrode 130. The respective electrical connections through the dielectric inorganic substrate 150 are then provided by the pattern of first metal structures 160 and the at least one second metal structure 170. In this and other cases the electrical component 710 may, in particular, be a Zener diode. The capacitance of the diode is then used for improving the performance of the semiconductor transistor chip 110.

Generally, the electrical component 710 may be connected between any two of all pads provided at the second surface 150B of the dielectric inorganic substrate 150, in particular between a LV load electrode pad (metallization 120M), a LV control electrode pad (metallization 130M), a LV control electrode ring pad, a HV load electrode pad and a HV load electrode ring pad 740.

Referring to Figure 8, the dielectric inorganic substrate 150 may also be used to provide for an additional voltage tap on the semiconductor device 800. The additional voltage tap may be implemented by a third metal structure 820 running through the dielectric inorganic substrate 150. The third metal structure 820 may connect an intermediate voltage region 850 at the semiconductor transistor chip 110 to an intermediate voltage pad 850M disposed on the second surface 150B of the dielectric inorganic substrate 150.

For example, one of the electrically floating (drain) rings 544 can be plated through the wafer to form the third metal structure 820. The third metal structure 820 can touch down on a very small (e.g. p-doped) conductive region on the semiconductor transistor chip 110. The conductive region can be very small, e.g. 1 one or a few square µm in size. The through-hole plating can also be very thin, for example a few µm. The pad 850M of the intermediate voltage tap is then located far away from the front side 110A of the semiconductor chip 110 and thus outside the region where it would influence the HV field.

The intermediate voltage region 850 may be located at a certain distance from the HV load electrode ring 140R and thus from the edge 110E of semiconductor transistor chip 110. The distance between the HV load electrode ring 140R and the tapped intermediate voltage region 850 determines the intermediate voltage. Differently stated, the offset of the intermediate voltage to HV (e.g. drain voltage) results from the positioning of the intermediate voltage tap, i.e. its position between the drain ring at the chip edge (i.e. the HV load electrode ring 140R) and the source area (i.e. the LV load electrode 120). For example the intermediate voltage can be equal to or less than or greater than 150 V or 50 V or 30 V or 20 V below the HV of the semiconductor transistor chip 110.

An intermediate voltage tap is usually not feasible on a chip, since no contactable contact surfaces can be placed on the semiconductor transistor chip 110 near the edge 110E, as such contact surfaces would disturb the HV field too much. It would be conceivable to pull out such an intermediate voltage with a line on the chip, but then the HV load electrode ring 140R would have to be redesigned. Differently stated, the dielectric inorganic substrate 150 provides the possibility to tap a desired intermediate voltage region 850 at the front side 110A of the semiconductor transistor chip 110 and to pull the appropriate intermediate voltage out upwards without changing field lines above the semiconductor transistor chip 110 in particular at the edge termination or requiring chip redesign for obtaining such intermediate voltage.

The intermediate voltage available at the intermediate voltage pad 850 can be used directly or can be supported against LV or HV by means of an electrical component 710 such as, e.g., a Zener diode connected between the intermediate voltage pad 850 and an LV metallization (e.g. 120M or 130M) or a HV metallization (e.g. 740). That means that the intermediate voltage tap can be combined with the concept of soldering active or passive components 710 onto the dielectric inorganic substrate 150 (e.g. between the intermediate tap and source or intermediate tap and gate).

The intermediate voltage pad 850 is not a power pad. For example, it can be a sense pad and/or it can be a pad which provides a voltage to switch a follower transistor. For example, a transistor connected in series can be controlled ON or OFF by such a tapped voltage set, e.g., 20 V or 30 V below the HV load electrode (e.g. drain) voltage. At present, it is to our knowledge not practicable to tap such a voltage from a HV semiconductor transistor chip, i.e., such control of a follower transistor as disclosed herein is currently not known.

As mentioned before, in all semiconductor devices 100, 300-800 the dielectric inorganic substrate 150 may comprise or be composed of a single layer dielectric inorganic substrate or a plurality of stacked dielectric inorganic substrate layers 150_1, 150_2, 150_3. In the latter case, each dielectric inorganic substrate layer 150_1, 150_2, 150_3 may be constructed the same way as described for the dielectric inorganic substrate 150. Implementing the dielectric inorganic substrate 150 by a multilayer structure, as shown in Figure 9, may facilitate the process of manufacturing thick dielectric inorganic substrates 150, since recess formation and metal plating can be carried out more conveniently with thinner structures, namely the layers 150_1, 150_2 and 150_3. For instance, if a thickness TS of 300 µm is desired, each of these processes needs only to be carried out on a dielectric inorganic substrate layer 150_1, 150_2, 150_3 of, e.g., a thickness of 50 µm or 100 µm.

The dielectric inorganic substrate layers 150_1, 150_2, 150_3 including, e.g., the first and second metal structures 160, 170 may be pre-fabricated and then aligned and bonded together to form the dielectric inorganic substrate 150. As noted before, layer bonding may be done on wafer-level, e.g. by using a glass frit connection between adjacent dielectric inorganic substrate layers 150_1, 150_2 and 150_3.

Further, this technique of stacking a plurality of dielectric inorganic substrate layers 150_1, 150_2, 150_3 allows to form blind hole metal structures 960 which do not extend through the dielectric inorganic substrate 150 but end in the dielectric inorganic substrate 150 at a dielectric inorganic substrate layer 150_1, 150_2 adjacent to the dielectric inorganic substrate layer 150_2, 150_3 which is provided with the blind hole metal structure 960. As described before, such blind hole metal structures 960 can, e.g., be used as field plates (e.g. source field plates 526, drain ring field plates 546, floating rings 544, etc.) which allow to appropriately effect the electrical field above the semiconductor transistor chip 110. Due to the layer-by-layer arrangement of the dielectric inorganic substrate 150, no true blind holes need to be fabricated to realize such blind hole metal structures 960 terminating in the dielectric inorganic substrate 150.

All ring structures described herein may be closed rings. The metal structures of all ring structures and fingers described herein may laterally contact to each other (see e.g. detail of Figure 4B) and/or may be implemented as continuous trenches to allow a lateral current flow through the ring structure or the finger, respectively, in the dielectric inorganic substrate 150.

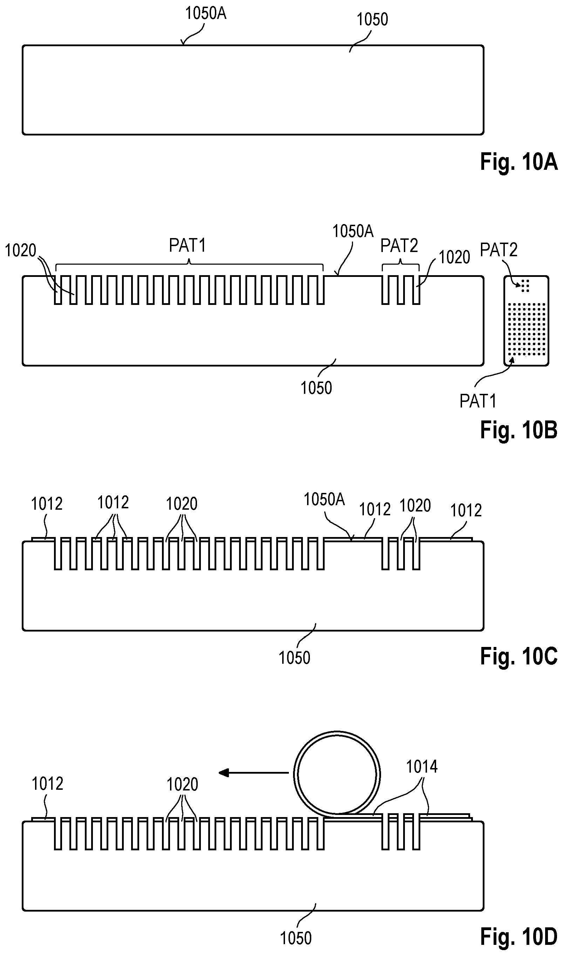

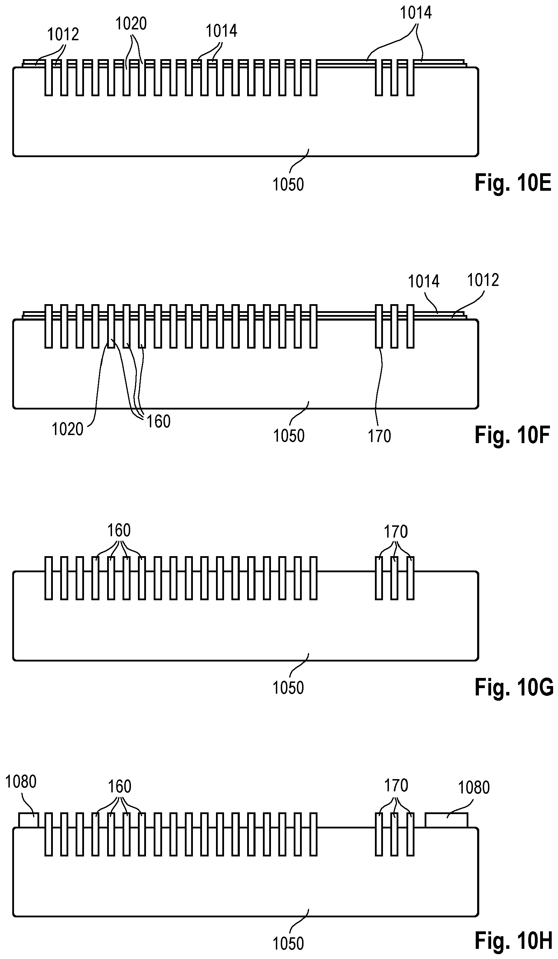

Figures 10A-10L illustrate exemplary stages of a process of manufacturing a semiconductor device 100, 300-800 in accordance with the disclosure.

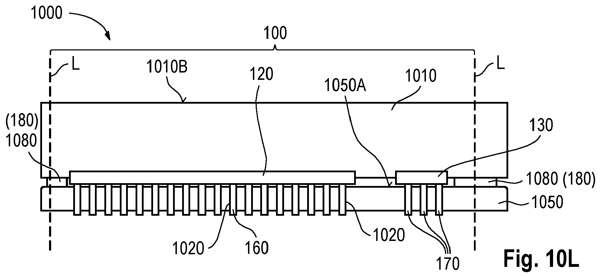

Referring to Figure 10A, a dielectric inorganic substrate wafer 1050 is provided. The dielectric inorganic substrate wafer 1050 may, e.g., have a thickness of 400 to 700 µm. The dielectric inorganic substrate wafer 1050 may, e.g., be a glass wafer or a semiconductor wafer. Figures 1000A-L illustrate only a portion of the dielectric inorganic substrate wafer 1050 which comprises, e.g., one semiconductor chip 110, see Figure 10L.

Figure 10B illustrates the formation of recesses 1020 in a first surface 1050A of the dielectric inorganic substrate wafer 1050. The recesses 1020 may be formed by etching. The dimensions (lateral dimensions, depths) of the recesses 1020 may correspond to the dimensions described above for the first metal structures 160.

According to Figure 10B, the dielectric inorganic substrate wafer 1050 may include (per chip) a first pattern PAT1 of recesses 1020 and a second pattern PAT2 of the recesses 1020. As shown on the right hand side of Figure 10B which illustrates a top view on a chip portion of the dielectric inorganic substrate wafer 1050, the area of PAT1 may, e.g., be substantially greater than the area of PAT2. Further, as mentioned before, the parameters (pitch, distance, shape, ...) of the recesses 1020 in PAT1 and in PAT2 may be different from each other or may be the same.

In one embodiment, only the first pattern PAT1 is formed as a pattern of recesses, while the second pattern PAT2 is replaced by another type of through connection such as, e.g., a single hole serving as a through connection for, e.g., the control electrode 130 of the semiconductor transistor chip 110.

Some of the recesses 1020 formed in the dielectric inorganic substrate wafer 1050 may have a depth which is smaller than the target thickness of the dielectric inorganic substrate wafer 1050 (i.e. TS of Figure 1), while other recesses 1020 have a depth greater than the target thickness of the dielectric inorganic substrate wafer 1050.

Referring to Figure 10C, a liner 1012 may optionally be deposited over the first surface 1050A of the dielectric inorganic substrate wafer 1050. The liner 1012 may, e.g., be an electrically conductive seed layer.

Referring to Figure 10D, a protective layer 1014 may be applied over the top surface of the dielectric inorganic substrate wafer 1050 and, e.g., over the liner 1012. The protective layer 1014 may be applied using a self-aligned process. That is, the protective layer 1014 may only be applied over parts of the first surface 1050A of the dielectric inorganic substrate wafer 1050 which are not recessed. The protective layer 1014 may, e.g., be applied by a rolling and/or printing process and may, e.g., completely cover the liner 1012 at non-recessed parts of the first surface 1050A of the dielectric inorganic substrate wafer 1050.

It is to be noted that the processes of liner 1012 deposition and/or protective layer 1014 deposition as shown in Figures 10C and 10D are optional processes, since metal plating, as described in the following, can also be carried out without liner 1012 and/or protective layer 1014 deposition.

Referring to Figure 10F, metal is plated to fill the recesses 1020. As a result, the first metal structures 160 are formed. The first metal structures 160 may completely fill the recesses 1020. Further, the second metal structures 170 may be formed.

The first metal structures 160 may protrude a small distance over the first surface 1050A of the dielectric inorganic substrate wafer 1050. Metal plating can be carried out by electro-chemical deposition (ECD). For instance, copper or a copper alloy may be used as a plating metal, but other metals known in the art to be suitable for package interconnects can also be used. The same may hold true for the second metal structure(s) 170.

Referring to Figure 10G, the protective layer 1014 (if present) and the liner 1012 (if present) are removed by, e.g., etching.

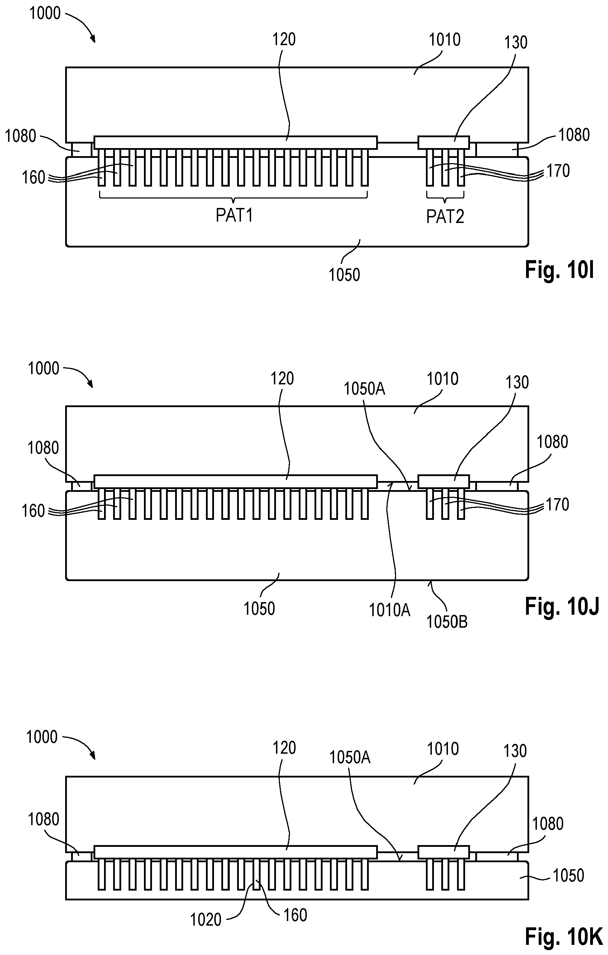

Referring to Figure 10H, a bonding material 1080 may be applied on the dielectric inorganic substrate wafer 1050. The bonding material 1080 may be applied on areas of the dielectric inorganic substrate wafer 1050 which correspond to inactive areas of a semiconductor wafer 1010 (see Figure 10I).

The bonding material 1080 may e.g. comprise or be glass glue (e.g. glass frit) or a resin or any other material suitable to permanently bond the dielectric inorganic substrate wafer 1050 to the semiconductor wafer 1010 (see Figure 10I).

Referring to Figure 10I, the front side of a semiconductor wafer 1010 is combined with the dielectric inorganic substrate wafer 1050 to form a composite wafer 1000. During this process the plurality of patterns of first metal structures 160 is placed opposite the plurality of LV load electrodes 120 on the semiconductor wafer 1010. Again, it is to be noted that Figure 101 only shows a partial view of the dielectric inorganic substrate wafer 1050 and the semiconductor wafer 1010 which substantially corresponds to one semiconductor transistor chip 110 in the semiconductor wafer 1010. Hence, the first pattern PAT1 of first metal structures 160 and the second pattern PAT2 of second metal structures 170 may form sub-patterns corresponding to two electrodes 120, 130 of a single semiconductor transistor chip 110 of the semiconductor wafer 1010.

The process of combining the semiconductor wafer 1010 and the dielectric inorganic substrate wafer 1050 as shown in Figure 101 may be carried out by using optical alignment through the dielectric inorganic substrate wafer 1050 (e.g. so-called through-glass alignment or through-semiconductor alignment). That is, an optical alignment processes may be carried out by viewing through the dielectric inorganic substrate wafer 1050 to recognize the position of the semiconductor wafer 1010 relative to the position of the dielectric inorganic substrate wafer 1050 so as to combine the semiconductor wafer 1010 and the dielectric inorganic substrate wafer 1050 in proper alignment.

The bonding material 1080 may have also been applied to the semiconductor wafer 1010 rather than to the dielectric inorganic substrate wafer 1050.

Figure 10J illustrates the process of bonding the semiconductor wafer 1010 to the dielectric inorganic substrate wafer 1050 with the front side 1010A of the semiconductor wafer 1010 facing the dielectric inorganic substrate wafer 1050. This process may concurrently connect the plurality of patterns of first metal structures 160 on the dielectric inorganic substrate wafer 1050 to the plurality of LV load electrodes 120 on the semiconductor wafer 1010. The process may be carried out by applying heat and pressure to the composite wafer 1000.

By virtue of this process the bonding 1080 material fixedly secures the semiconductor wafer 1010 to the dielectric inorganic substrate wafer 1050. Further, by this or another process, the first metal structures 160 may be electrically and mechanically fixedly connected to the LV load electrodes 120. The connections may be solder-free, i.e. no solder material may be used for establishing the electrical, mechanical and thermal connection between the LV load electrodes 120 and the first metal structures 160. By way of example, the connection may be created by the formation of an eutectic phase between the metal of the LV load electrodes 120 and the metal of the first metal structures 160. The same may hold true for the connection of the second metal structures 170 to the control electrodes 130.

Referring to Figures 10K and 10L, the dielectric inorganic substrate wafer 1050 may be thinned from a second surface 1050B (see Figure 10J) opposite the first surface 1050A to expose the metal of at least a part or of all of the metal structures 160 in the recesses 1020.

More specifically, thinning may, e.g., be carried out in a multi-stage process. For instance, as shown in Figure 10K, thinning may comprise grinding the dielectric inorganic substrate wafer 1050 down to a thickness which is only slightly larger than the depth of the recesses 1020. For instance, grinding may stop at a distance of equal to or less than 20 µm or 15 µm or 10 µm over the bottom of the recesses 1020.

The first metal structures 160 or at least a part of them may then be exposed by etching the dielectric inorganic substrate wafer 1050 down to the thickness TS (see Figure 1). Etching may be carried out by wet or dry chemical etching. Etching may be continued until the first metal structures 160 (or at least some of them) and e.g. also the second metal structures 170 protrude a small distance such as, e.g., a few µm over the bottom surface of the thinned dielectric inorganic substrate wafer 1050. The bottom surface of the thinned dielectric inorganic substrate wafer 1050 may correspond to the second surface 150B of the dielectric inorganic substrate 150 as shown in Figure 1.

In the following, the back-end-of-line (BEOL) processes of chip packaging may be carried out on the composite wafer 1000 shown in Figure 10L. In this context, the composite wafer 1000 is separated along dicing lines L into composite chips corresponding to semiconductor devices 100. Separating the composite wafer 1000 into composite chips may be carried out by any suitable dicing methods, e.g. mechanical sawing, laser dicing and/or etching. As a result, the high voltage semiconductor transistor chip 110 and the dielectric inorganic substrate 150 may have aligned cutting edges.

The following examples pertain to further aspects of the disclosure:

Example 1 is a semiconductor device comprises a high voltage semiconductor transistor chip comprising a front side and a backside. A low-voltage load electrode and a control electrode are disposed on the front side of the semiconductor transistor chip. The semiconductor device further comprises a dielectric inorganic substrate comprising a first side and a second side opposite the first side. A pattern of first metal structures is running through the dielectric inorganic substrate, wherein the pattern of first metal structures is connected to the low-voltage load electrode. At least one second metal structure is running through the dielectric inorganic substrate, wherein the second metal structure is connected to the control electrode. The front side of the semiconductor transistor chip is attached to the first side of the dielectric inorganic substrate. The dielectric inorganic substrate has a thickness measured between the first side and the second side of at least 50 µm.

In Example 2, the subject matter of Example 1 can optionally include wherein the dielectric inorganic substrate comprises a control pad disposed on the second side of the dielectric inorganic substrate, the second metal structure connecting the control pad, wherein the control pad has an area which is greater than an area of the control electrode by at least a factor 3 and/or an edge of the control pad is closer to an edge of the semiconductor transistor chip than an edge of the control electrode.

In Example 3, the subject matter of Example 1 or 2 can optionally include wherein the dielectric inorganic substrate comprises a control electrode ring surrounding an active area of the semiconductor transistor chip in a vertical projection, wherein the control electrode ring is embedded in the dielectric inorganic substrate.

In Example 4, the subject matter of any of the preceding Examples can optionally include wherein the dielectric inorganic substrate comprises at least one control electrode finger extending into an active area of the semiconductor transistor chip in a vertical projection, wherein the control electrode finger is embedded in the dielectric inorganic substrate.

In Example 5, the subject matter of any of the preceding Examples can optionally include a high voltage load electrode ring extending adjacent to an edge of the semiconductor transistor chip, wherein the high voltage load electrode ring is partly or completely embedded in the dielectric inorganic substrate.

In Example 6, the subject matter of Example 5 can optionally include wherein the high voltage load electrode ring comprises electrically floating rings embedded in the dielectric inorganic substrate.

In Example 7, the subject matter of Example 5 or 6 can optionally include high voltage load electrode field plates embedded in the dielectric inorganic substrate, wherein the high voltage load electrode field plates are vertical metal structures electrically connected to the high voltage load electrode ring.

In Example 8, the subject matter of any of the preceding Examples can optionally include low-voltage load electrode field plates, wherein the low-voltage load electrode field plates are vertical metal structures electrically connected to the low-voltage load electrode.

In Example 9, the subject matter of any of the preceding Examples can optionally include control electrode field plates, wherein the control electrode field plates are vertical metal structures electrically connected to the control electrode.

In Example 10, the subject matter of any of the preceding Examples can optionally include a barrier layer disposed on the first side the dielectric inorganic substrate.

In Example 11, the subject matter of Example 10 can optionally include wherein the barrier layer is arranged between a high voltage load electrode or a high voltage load electrode ring disposed on the front side of the semiconductor transistor chip and the low-voltage load electrode or the control electrode of the semiconductor transistor chip.

In Example 12, the subject matter of any of the preceding Examples can optionally include an active or passive electrical component mounted on the second side of the dielectric inorganic substrate.

In Example 13, the subject matter of Example 12 can optionally include wherein the electrical component is electrically connected between the pattern of first metal structures and the at least one second metal structure or between a high voltage metal pad disposed on the second side of the dielectric inorganic substrate and the at least one second metal structure.

In Example 14, the subject matter of any of the preceding Examples can optionally include a third metal structure running through the dielectric inorganic substrate, wherein the third metal structure is connected to an intermediate voltage region on the front side of the semiconductor transistor chip, the intermediate voltage region being located near an edge of the semiconductor transistor chip, and to an intermediate voltage pad disposed on the second side of the dielectric inorganic substrate.

In Example 15, the subject matter of any of the preceding Examples can optionally include wherein the dielectric inorganic substrate is a glass substrate.

In Example 16, the subject matter of any of the preceding Examples can optionally include wherein the front side of the semiconductor transistor chip is attached to the first side of the dielectric inorganic substrate by a wafer bond connection, in particular a glass frit connection.

In Example 17, the subject matter of any of the preceding Examples can optionally include wherein the first metal structures and/or the at least one second metal structure are plated metal pillars.

In Example 18, the subject matter of any of the preceding Examples can optionally include wherein the dielectric inorganic substrate comprises a plurality of stacked dielectric inorganic substrate layers.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor device, comprising:
a high-voltage semiconductor transistor chip comprising a front side and a backside, wherein a low-voltage load electrode and a control electrode are disposed on the front side of the semiconductor transistor chip;
a dielectric inorganic substrate comprising a first side and a second side opposite the first side;
a pattern of first metal structures running through the dielectric inorganic substrate, wherein the pattern of first metal structures is connected to the low-voltage load electrode; and
at least one second metal structure running through the dielectric inorganic substrate, wherein the second metal structure is connected to the control electrode; wherein
the front side of the semiconductor transistor chip is attached to the first side the dielectric inorganic substrate, and
the dielectric inorganic substrate has a thickness measured between the first side and the second side of at least 50 µm.

2. The semiconductor device of claim 1, wherein the dielectric inorganic substrate comprises a control pad disposed on the second side of the dielectric inorganic substrate, the second metal structure connecting the control pad, wherein
the control pad has an area which is greater than an area of the control electrode by at least a factor 3 and/or
an edge of the control pad is closer to an edge of the semiconductor transistor chip than an edge of the control electrode.

3. The semiconductor device of claim 1 or 2, wherein the dielectric inorganic substrate comprises a control electrode ring surrounding an active area of the semiconductor transistor chip in a vertical projection, wherein the control electrode ring is embedded in the dielectric inorganic substrate.

4. The semiconductor device of any of the preceding claims, wherein the dielectric inorganic substrate comprises at least one control electrode finger extending into an active area of the semiconductor transistor chip in a vertical projection, wherein the control electrode finger is embedded in the dielectric inorganic substrate.

5. The semiconductor device of any of the preceding claims, further comprising:
a high-voltage load electrode ring extending adjacent to an edge of the semiconductor transistor chip, wherein
the high-voltage load electrode ring is partly or completely embedded in the dielectric inorganic substrate.

6. The semiconductor device of claim 5, wherein the high-voltage load electrode ring comprises electrically floating rings embedded in the dielectric inorganic substrate.

7. The semiconductor device of claim 5 or 6, further comprising:
high-voltage load electrode field plates embedded in the dielectric inorganic substrate, wherein the high-voltage load electrode field plates are vertical metal structures electrically connected to the high-voltage load electrode ring.

8. The semiconductor device of any of the preceding claims, further comprising:
low-voltage load electrode field plates, wherein the low-voltage load electrode field plates are vertical metal structures electrically connected to the low-voltage load electrode.

9. The semiconductor device of any of the preceding claims, further comprising:
control electrode field plates, wherein the control electrode field plates are vertical metal structures electrically connected to the control electrode.

10. The semiconductor device of any of the preceding claims, further comprising:
a barrier layer disposed on the first side the dielectric inorganic substrate.

11. The semiconductor device of claim 10, wherein the barrier layer is arranged between a high-voltage load electrode or a high-voltage load electrode ring disposed on the front side of the semiconductor transistor chip and the low-voltage load electrode or the control electrode of the semiconductor transistor chip.

12. The semiconductor device of any of the preceding claims, further comprising:
an active or passive electrical component mounted on the second side of the dielectric inorganic substrate.

13. The semiconductor device of claim 12, wherein the electrical component is electrically connected between the pattern of first metal structures and the at least one second metal structure or between a high-voltage metal pad disposed on the second side of the dielectric inorganic substrate and the at least one second metal structure.

14. The semiconductor device of any of the preceding claims, further comprising:
a third metal structure running through the dielectric inorganic substrate, wherein the third metal structure is connected
to an intermediate voltage region on the front side of the semiconductor transistor chip, the intermediate voltage region being located near an edge of the semiconductor transistor chip, and
to an intermediate voltage pad disposed on the second side of the dielectric inorganic substrate.

15. The semiconductor device of any of the preceding claims, wherein the dielectric inorganic substrate is a glass substrate.

16. The semiconductor device of any of the preceding claims, wherein the front side of the semiconductor transistor chip is attached to the first side of the dielectric inorganic substrate by a wafer bond connection, in particular a glass frit connection.

17. The semiconductor device of any of the preceding claims, wherein the first metal structures and/or the at least one second metal structure are plated metal pillars.

18. The semiconductor device of any of the preceding claims, wherein the dielectric inorganic substrate comprises a plurality of stacked dielectric inorganic substrate layers.
